# EUROPEAN PATENT APPLICATION

(11) **EP 2 051 288 A1**
(43) Date of publication of application: **22.04.2009**
(21) Application number: 07745330.6
(22) Date of filing: 15.06.2007
(51) Int. Cl.: H01L 21/304, B08B 3/08, B08B 3/12, C30B 29/38, H01L 33/00

(54) **GaxIn1-xN SUBSTRATE AND GaxIn1-xN SUBSTRATE CLEANING METHOD**

(30) Priority: 07.08.2006 JP 2006214537
(71) Applicant: Sumitomo Electric Industries, Ltd., Osaka-shi, Osaka 541-0041 (JP)
(72) Inventor: UEMURA, Tomoki, tami-shi, Hyogo 6640016 (JP); NAKAHATA, Hideaki, tami-shi, Hyogo 6640016 (JP)
(74) Representative: Grünecker, Kinkeldey, Stockmair & Schwanhäusser Anwaltssozietät
(86) International application number: PCT/JP2007/062075
(87) International publication number: WO 2008/018237

(57) **Abstract**

Affords Ga*ₓ*In_{1-*x*}N substrates onto which high-quality epitaxial films can be stably grown, and cleaning methods for manufacturing the Ga*ₓ*In_{1-*x*}N substrates.

Ga*ₓ*In_{1-*x*}N substrate in which the number of particles of not less than 0.2 µm particle size present on the Ga*ₓ*In_{1-*x*}N substrate surface is 20 or fewer, given that the Ga*ₓ*In_{1-*x*}N substrate diameter is 2 inches. Furthermore, a Ga*ₓ*In_{1-*x*}N substrate in which in a photoelectron spectrum along the Ga*ₓ*In_{1-*x*}N substrate surface by X-ray photoelectron spectroscopy at a take-off angle of 10°, the ratio between the peak areas of the C1*s* electron and N1*s* electron (C 1*s* electron peak area/N 1*s* electron peak area) is 3 or less.

## Description

### Technical Field

The present invention relates to Ga*ₓ*In_{1-*x*}N (0 ≤ *x* ≤ 1) substrates, and to methods of cleaning Ga*ₓ*In_{1-*x*}N (0 ≤ *x* ≤ 1) substrates.

### Background Art

Among Ga*ₓ*In_{1-*x*}N (0 ≤ *x* ≤ 1) substrates, GaN (gallium nitride) substrates, on account of their having an energy bandgap of 3.4 eV and high thermal conductivity, have gained attention as materials for such semiconductor devices as short-wavelength emitting light sources and power electronic devices.

Hydride vapor phase epitaxy (HVPE) is one typical technique for growing GaN crystal, and it allows GaN substrates to be manufactured from the GaN crystal. Then, by growing various epitaxial films superficially onto the GaN substrates, optoelectronic and other semiconductor devices can be obtained. As substrates onto which GaN epitaxial films free of surface roughness can be grown, in Patent Document 1, for example, nitride crystal substrates, such as GaN substrates, whose surface carrier density is uniform have been proposed.

Nevertheless, even when substrates described in Patent Document 1 are employed, low-quality epitaxial films have at times been grown, in which, not reflecting the uniformity in carrier density along the substrate surface, defects and haze not related to it appear. Because the device characteristics of semiconductor devices employing low-quality epitaxial films of this sort are harmed, there is a strongly felt need for stably growing high-quality epitaxial films having minimal defects and haze.
*Patent Document 1:* Japanese Unexamined Pat. App. Pub. No. 2005-101475

### Disclosure of Invention

### Problems Invention Is to Solve

Prior art literature making mention of the extent to which particles and organic matter clinging to the surface of Ga*ₓ*In_{1-*x*}N substrates such as GaN substrates is removed in order to stably grow high-quality epitaxial films having minimal defects and haze being nil, however, the criteria are unclear, and a consequent problem has been that variations in Ga*ₓ*In_{1-*x*}N substrate surface condition have as such led directly to variations in epitaxial film quality.

An object of the present invention is to make available Ga*ₓ*In_{1-*x*}N substrates onto which high-quality epitaxial films can be stably grown, and cleaning methods for obtaining the Ga*ₓ*In₁₋*x*N substrates.

### Means for Resolving the Problems

One aspect of the present invention is a Ga*ₓ*In_{1-*x*}N substrate in which the number of particles of not less than 0.2 µm particle size present on the Ga*ₓ*In_{1-*x*}N substrate surface is 20 or fewer, given that the Ga*ₓ*In_{1-*x*}N substrate diameter is 2 inches. Herein, in the present description, "Ga*ₓ*In_{1-*x*}N substrates" refer to nitride crystal substrates including at least one of gallium (Ga) and indium (In).

The present invention is also a Ga*ₓ*In_{1-*x*}N substrate cleaning method of cleaning a Ga*ₓ*In_{1-*x*}N substrate by immersing it in a cleaning solution being any one substance selected from the group consisting of aqueous ammonia, ammonium hydroxide-hydrogen peroxide-water mixture, and aqueous organic alkali solutions, while applying ultrasonic waves to the solution, to bring the number of particles of not less than 0.2 µm particle size present on the Ga*ₓ*In_{1-*x*}N substrate surface to 20 or fewer, given that the Ga*ₓ*In_{1-*x*}N substrate diameter is 2 inches.

Herein, in the Ga*ₓ*In_{1-*x*}N substrate cleaning method of the present invention, as the cleaning solution, any one of aqueous ammonia in which the ammonia concentration is 0.5% by mass or more, ammonium hydroxide-hydrogen peroxide-water mixture in which the aqueous hydrogen peroxide concentration is 0.1% by mass or more, with the ammonia concentration being 0.1% by mass or more, and an aqueous organic alkali solution in which the organic alkali concentration is 0.5% by mass or more is preferably utilized.

Furthermore, in a Ga*ₓ*In_{1-*x*}N substrate cleaning method of the present invention, the aqueous organic alkali solution is preferably a solution in which an organic alkali being one of either tetramethylammonium hydroxide or trimethyl-2-hidroxyethyl ammonium hydroxide is dissolved in water.

Additionally, in a Ga*ₓ*In_{1-*x*}N substrate cleaning method of the present invention, the Ga*ₓ*In_{1-*x*}N substrate immersion time is preferably 30 seconds or more.

The present invention further is a Ga*ₓ*In_{1-*x*}N substrate in which in a photoelectron spectrum along the Ga*ₓ*In_{1-*x*}N substrate surface by X-ray photoelectron spectroscopy at take-off angle of 10°, the ratio between the peak areas of the C1*s* electron and N1*s* electron (C 1*s* electron peak area / N 1*s* electron peak area) is 3 or less.

The present invention is furthermore a Ga*ₓ*In_{1-*x*}N substrate cleaning method of immersing a Ga*ₓ*In_{1-*x*}N substrate in an acid solution to bring the ratio between the peak areas of the C1*s* electron and N1*s* electron (C 1*s* electron peak area / N 1*s* electron peak area) to 3 or less in a photoelectron spectrum along the Ga*ₓ*In_{1-*x*}N substrate surface by X-ray photoelectron spectroscopy at a take-off angle of 10°.

Herein, in the Ga*ₓ*In_{1-*x*}N substrate cleaning method of the present invention, the acid solution is preferably composed of either at least one substance selected from the group consisting of fluoric acid, hydrochloric acid, and sulfuric acid, or an admixed solution of aqueous hydrogen peroxide and at least one substance selected from the group consisting of fluoric acid, hydrochloric acid, and sulfuric acid.

Furthermore, in a Ga*ₓ*In_{1-*x*}N substrate cleaning method of the present invention, it is preferable that in implementations in which the acid solution is composed of at least one substance selected from the group consisting of fluoric acid, hydrochloric acid, and sulfuric acid, the total concentration of fluoric acid, hydrochloric acid, and sulfuric acid in the acid solution is 0.5% by mass or more, and in implementations in which the acid solution is composed of an admixed solution of aqueous hydrogen peroxide and at least one substance selected from the group consisting of fluoric acid, hydrochloric acid, and sulfuric acid, the total concentration of fluoric acid, hydrochloric acid, and sulfuric acid in the acid solution is 0.1% by mass or more, with aqueous hydrogen peroxide concentration being 0.1% by mass or more.

Additionally, in a Ga*ₓ*In_{1-*x*}N substrate cleaning method of the present invention, the Ga*ₓ*In_{1-*x*}N substrate immersion time is preferably 30 seconds or more.

### Effects of the Invention

The present invention affords Ga*ₓ*In_{1-*x*}N substrates onto which high-quality epitaxial films can be stably grown, and cleaning methods for obtaining the Ga*ₓ*In_{1-*x*}N substrates.

### Brief Description of Drawings

Fig. 1 is a schematic diagram used to explain one example of X-ray photoelectron spectroscopy, at a take-off angle of 10°, in the present invention.
Fig. 2 is a schematic sectional diagram of a cleaning apparatus employed in Experimental Example 1.
Fig. 3 is a graph plotting the relationship, in Experimental Example 1, between the number of particles and the number of defects in an epitaxial film grown onto the surface of a GaN substrate.
Fig. 4 is a schematic sectional view of a cleaning apparatus employed in Experimental Example 2.

### Legend

- 1:: cleaning bath
- 2:: cleaning solution
- 2*a*:: acid solution
- 3:: ultrasonic waves
- 4:: GaN substrate
- 5:: Ga*ₓ*In_{1-*x*}N substrate
- 6:: X-rays
- 7:: photoelectrons
- 8:: detector

### Best Mode for Carrying Out the Invention

Below, a description of modes of embodying the present invention will be made. It should be understood that in the drawings for the present invention, identical reference marks indicate identical or corresponding parts.

The present invention is a Ga*ₓ*In_{1-*x*}N substrate in which the number of particles of not less than 0.2 µm particle size present on the Ga*ₓ*In_{1-*x*}N substrate surface is 20 or fewer, given that the diameter of the Ga*ₓ*In_{1-*x*}N substrate is 2 inches. It being that, as a result of concentrated investigative efforts, the present inventors discovered that if the number of particles of not less than 0.2 µm particle size that are on the Ga*ₓ*In_{1-*x*}N substrate surface is controlled as just noted, high-quality epitaxial films having fewer defects can be grown.

Herein, the number of particles on the Ga*ₓ*In_{1-*x*}N substrate surface is calculated by counting all of the particles of not less than 0.2 µm particle size present globally across the Ga*ₓ*In_{1-*x*}N substrate surface, and converting the counted number of particles to a value hypothesized for when the diameter of the Ga*ₓ*In_{1-*x*}N substrate is 2 inches. Accordingly, in the present invention, the size of the Ga*ₓ*In_{1-*x*}N substrate is not limited. For example, inasmuch as the surface area of a Ga*ₓ*In_{1-*x*}N substrate whose diameter is 4 inches is four times that of one that is 2 inches, in implementations employing Ga*ₓ*In_{1-*x*}N substrates whose diameter is 4 inches, 1/4 of the total number of particles present on their surface will be what herein is termed the particle count. It should be noted that particles are counted employing equipment such as hitherto publicly known light-scattering substrate-surface inspection devices. Furthermore, the particle substances are not, in particular, limited.

The present invention is also a method of cleaning a Ga*ₓ*In_{1-*x*}N substrate by immersing it in a cleaning solution being any one substance selected from the group consisting of aqueous ammonia, ammonium hydroxide-hydrogen peroxide-water mixture, and aqueous organic alkali solutions, while applying ultrasonic waves to the solution, to bring the number of particles of not less than 0.2 µm particle size present on the Ga*ₓ*In_{1-*x*}N substrate surface to 20 or fewer, given that the Ga*ₓ*In_{1-*x*}N substrate diameter is 2 inches.

Herein, "ammonium hydroxide-hydrogen peroxide-water mixture" is an admixed solution of aqueous hydrogen peroxide and aqueous ammonia, thus not being limited to admixed solutions in which aqueous hydrogen peroxide has been added to aqueous ammonia. Further, "aqueous organic alkali solutions" are solutions in which an organic alkali has been dissolved in water, wherein either of tetramethylammonium hydroxide expressed by the following structural formula (1), or trimethyl-2-hidroxyethyl ammonium hydroxide expressed by the following structural formula (2), is preferably utilized as the organic alkali.

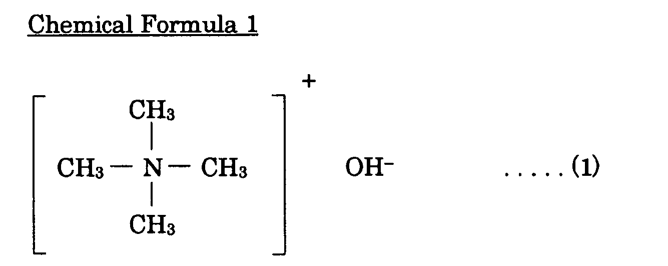

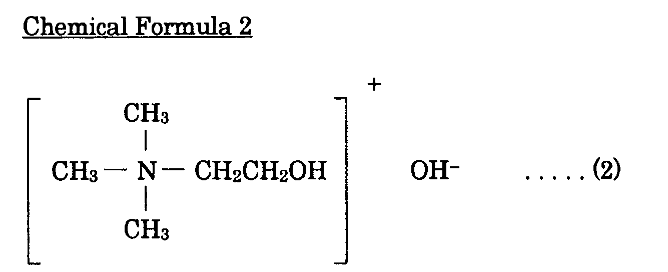

Furthermore, in implementations in which aqueous ammonia is utilized as the cleaning solution, the ammonia concentration with respect to the cleaning solution as a whole is preferably 0.5% by mass or more. And in implementations in which ammonium hydroxide-hydrogen peroxide-water mixture is utilized as the cleaning solution, the aqueous hydrogen peroxide concentration with respect to the cleaning solution as a whole is preferably 0.1% by mass or more, with the ammonia concentration being 0.1% by mass or more. Still further, in implementations in which an aqueous organic alkali solution is utilized as the cleaning solution, the organic alkali concentration with respect to the cleaning solution as a whole is preferably 0.5% by mass or more. Thus regulating concentration in the cleaning solution tends to make the particle count on the Ga*ₓ*In_{1-*x*}N substrate surface more stable, making it possible to control the count in the manner described above.

Further, the period for which the Ga*ₓ*In_{1-*x*}N substrate is immersed in the cleaning solution is preferably 30 seconds or more. In this case, the fact that the Ga*ₓ*In_{1-*x*}N substrate is sufficiently immersed in the cleaning solution tends to make the particle count on the Ga*ₓ*In_{1-*x*}N substrate surface more stable, making it possible to control the count in the manner described above. Herein, the Ga*ₓ*In_{1-*x*}N substrate immersion time is the time from the point at which ultrasonic waves are applied to the cleaning solution.

The present invention further is a Ga*ₓ*In_{1-*x*}N substrate in which in a photoelectron spectrum along the Ga*ₓ*In_{1-*x*}N substrate surface by X-ray photoelectron spectroscopy (XPS) at a take-off angle of 10°, the ratio between the peak areas of the C1*s* electron and N1*s* electron (C 1*s* electron peak area/N 1*s* electron peak area) is 3 or less. It being that, as a result of concentrated investigative efforts, the present inventors discovered that if the ratio between the C 1*s* electron peak area and the N 1*s* electron peak area in a photoelectron spectrum along the Ga*ₓ*In_{1-*x*}N substrate surface by X-ray photoelectron spectroscopy at a take-off angle of 10° is controlled as just noted, high-quality epitaxial films free of haze can be grown. Herein, the ratio between the C 1*s* and N 1*s* electron peak areas in a photoelectron spectrum along the Ga*ₓ*In_{1-*x*}N substrate surface by X-ray photoelectron spectroscopy (XPS) at a take-off angle of 10° indicates the amount of organic matter on the Ga*ₓ*In_{1-*x*}N substrate surface with respect to nitrogen in the near-surface of the Ga*ₓ*In_{1-*x*}N substrate, wherein controlling the proportion in the manner just noted enables growing haze-free high-quality epitaxial films.

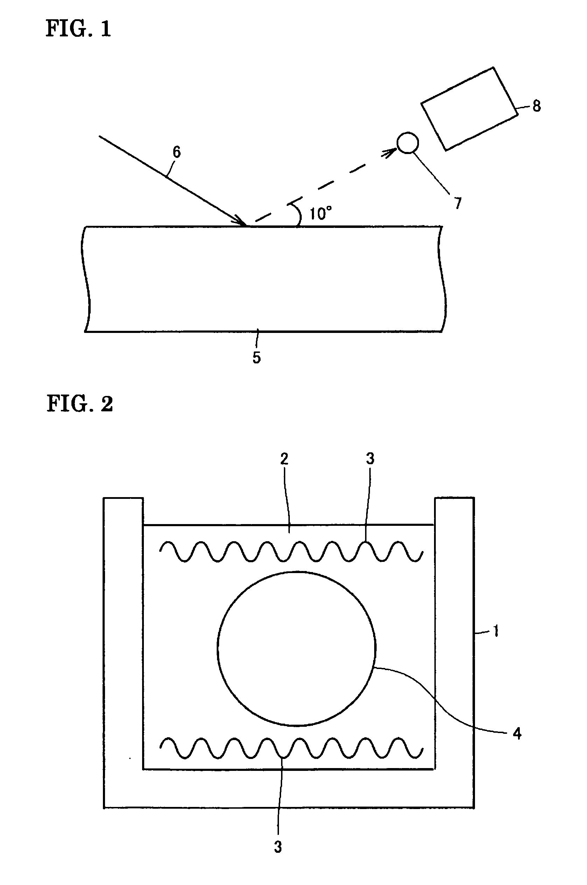

Herein, the C 1*s* electron refers to 1*s-*orbital electrons in carbon (C), and the N 1*s* electron refers to 1*s-*orbital electrons in nitrogen (N). Then, as illustrated in Fig. 1, irradiating a Ga*ₓ*In_{1-*x*}N substrate 5 with X-rays 6 releases C1*s* and N1*s* electrons in the surface as photoelectrons 7. Thereafter, the released photoelectrons 7, forming an angle of 10° with the surface of the Ga*ₓ*In_{1-*x*}N substrate 5 are (at a take-off angle of 10°) detected by a detector 8, yielding a photoelectron spectrum. The ratio between the C 1*s* electron peak area and the N 1*s* electron peak area in the photoelectron spectrum is found.

The present invention is furthermore a cleaning method of immersing a Ga*ₓ*In_{1-*x*}N substrate in an acid solution to bring the ratio between the peak areas of the C1*s* electron and N1*s* electron (C 1*s* electron peak area / N 1*s* electron peak area) is 3 or less in a photoelectron spectrum along the Ga*ₓ*In_{1-*x*}N substrate surface by X-ray photoelectron spectroscopy at a take-off angle of 10°.

Herein, the acid solution is preferably composed of either at least one substance selected from the group consisting of fluoric acid, hydrochloric acid, and sulfuric acid, or an admixed solution of aqueous hydrogen peroxide and at least one substance selected from the group consisting of fluoric acid, hydrochloric acid, and sulfuric acid. These implementations tend to make the just-noted ratio between the C 1*s* electron peak area and the N 1*s* electron peak area more stable, making it possible to bring it to 3 or less.

Furthermore, in implementations in which the acid solution is composed of least one substance selected from the group consisting of fluoric acid, hydrochloric acid, and sulfuric acid, the total concentration of fluoric acid, hydrochloric acid, or sulfuric acid in the acid solution is preferably 0.5% by mass or more. On the other hand, in implementations in which the acid solution is composed of an admixed solution of aqueous hydrogen peroxide and at least one substance selected from the group consisting of fluoric acid, hydrochloric acid, and sulfuric acid, the total concentration of fluoric acid, hydrochloric acid, or sulfuric acid in the acid solution is preferably 0.1% by mass or more, with the aqueous hydrogen peroxide concentration being 0.1% by mass or more. These implementations tend to make the just-noted ratio between the C 1*s* electron peak area and the N 1*s* electron peak area further stable, making it possible to bring the proportion to 3 or less.

Also, the period for which the Ga*ₓ*In_{1-*x*}N substrate is immersed in the acid solution is preferably 30 seconds or more. In this case, the fact that the Ga*ₓ*In_{1-*x*}N substrate is sufficiently immersed in the acid solution tends to make the just-noted ratio between the C 1*s* electron peak area and the N 1*s* electron peak area more stable, making it possible to control the proportion in the way just described.

### Embodiments

### Experimental Example 1

First, 50 GaN substrates of 2 inch-diameter were prepared, the GaN substrates being produced by specular-polishing a GaN crystal grown by HVPE, and then by removing the layer damaged by the specular-polishing. Herein, the 50 GaN substrates each were 400 µm in thickness, and their surfaces were the faces oriented at 2° with respect to the (0001) orientation.

Next, employing a cleaning apparatus as illustrated in the schematic sectional diagram in Fig. 2, cleaning was carried out, while immersion time was varied for each of the 50 GaN substrates. Herein, in a cleaning bath 1 as illustrated in Fig. 2, aqueous tetramethylammonium hydroxide solution at various concentrations was contained as the cleaning solution 2. Furthermore, under the same conditions for each of the 50 GaN substrates 4, ultrasonic waves 3 having frequency of 900 kHz were applied to the cleaning solution 2 in which GaN substrates 4 were immersed.

Then, in each of the GaN substrates after cleaning, with a light-scattering substrate surface-inspecting device, the numbers of particles present on the GaN substrate surfaces, having a particle size of 0.2 µm or more were counted.

After that, a 1 µm-thick epitaxial film composed of GaN crystal was grown onto the surface of each of the 50 GaN substrates by metalorganic vapor phase epitaxy (MOVPE) under the same conditions. Then, employing the same light-scattering substrate surface-inspecting device as the above device, the number of defects in the epitaxial film was counted.

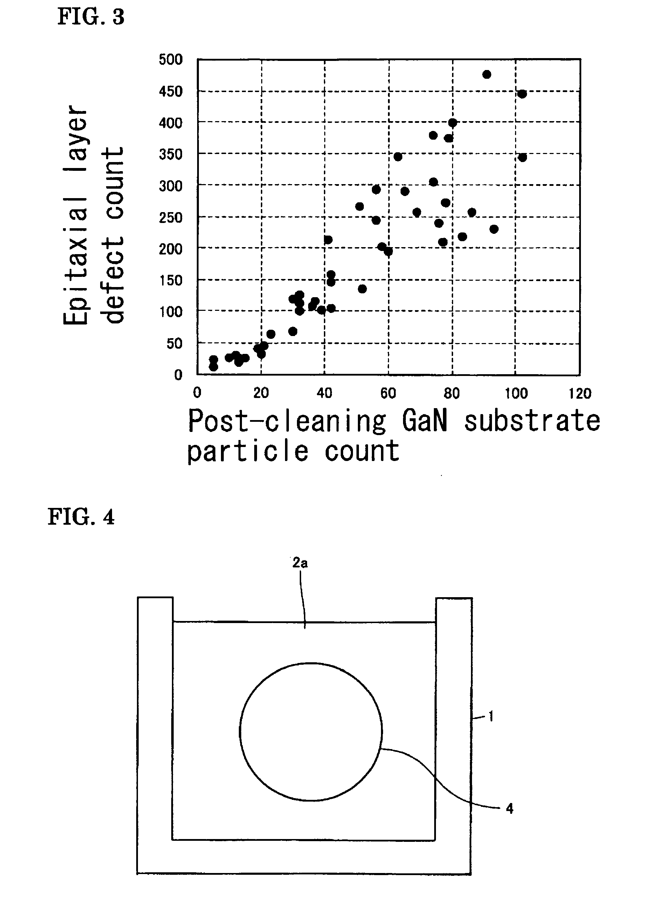

Results of the experiment were plotted and shown in Fig. 3. In Fig. 3, the horizontal axis represents the number of particles counted in the above manner, present on the surfaces of the GaN substrates after cleaning, having a particle size of 0.2 µm or more, and the vertical axis represents the number of counted defects in the epitaxial films grown onto the GaN substrate surfaces corresponding to the number of the particles on the horizontal axis.

As is clear from Fig. 3, in the situation in which the number of particles present on the surface of a GaN substrate of 2 inch-diameter, having a particle size of 0.2 µm or more was brought to 20 or fewer, the number of defects in an epitaxial film grown onto the surface was fewer than 50, and high-quality epitaxial film having fewer detects could be formed, compared with the situation in which the number of particles was more than 20.

Furthermore, a GaN substrate in which the number of particles present on the substrate surface, having a particle size of 0.2 µm or more was 20 or fewer was a substrate cleaned with tetramethylammonium hydroxide concentration with respect to the cleaning solution as a whole being brought to 0.5% by mass or more, and with the time required to immerse the GaN substrate being made 30 seconds or more.

It should be understood that although GaN substrates were employed in Experimental Example 1, the same results are believed to be obtained if other Ga*ₓ*In_{1-*x*}N substrates, apart from GaN substrates, are employed. Additionally, GaN substrate thickness and plane orientation are not limited to the above example, and even if the thickness and plane orientation are arbitrary, the same results as in Experimental Example 1 will be obtained.

### Experimental Example 2

First, as in Experimental Example 1, 50 GaN substrates of 2 inch-diameter were prepared, the GaN substrates being produced by specular-polishing a GaN crystal, and then removing a layer damaged by the specular-polishing. Herein, the 50 GaN substrates each is 400 µm in thickness, and the GaN substrate surfaces are the faces oriented at 2° with respect to the (0001) orientation.

Next, employing a cleaning apparatus as a schematic sectional diagram in Fig. 4 illustrated, cleaning was carried out, while immersing time was varied for each of the 50 GaN substrates. Herein, in a cleaning bath 1 as illustrated in Fig. 4, hydrochloric acid at various concentrations was contained as an acid solution 2*a*, and GaN substrates 4 each were immersed in the acid solution 2*a*.

Then, in each of the GaN substrates after cleaning, photoelectron spectrum on the GaN substrate surfaces at a photoelectron take-off angle of 10° was measured by an X-ray photoelectron spectrometer in which Kα-rays of Mg and A1 is utilized as X-ray source, and based on the peak area of an O 1*s* electron (1*s*-orbital electron in oxygen), a ratio of the peak area of a C 1*s* electron to the peak area of a N 1*s* electron (C 1*s* electron peak area / N 1*s* electron peak area) was calculated.

After the calculation, a 1 µm-thick epitaxial film composed of GaN crystal was grown onto the surface of each of the 50 GaN substrates by MOVPE under the same conditions. Then, whether haze occurred or not in each of the grown epitaxial films was visually evaluated by the following standards, and epitaxial films in which haze occurred were counted in each of sections represented by (C 1*s* electron peak area/N 1*s* electron peak area) shown in the table. The results are set forth in the table.

**Table**

| (C 1*s* electron peak area/ N 1*s* electron peak area) | 3 or less | Greater than 3; 5 or less | Greater than 5 |
|---|---|---|---|
| Number of GaN substrates with haze occurrence/total number of GaN substrates | 0/ 15 | 7 /23 | 10 / 11 |

### Evaluation Criteria for Presence of Haze Occurrences

Haze occurs: there is a part in which epitaxial film is not specular surface.
Haze does not occur: the entire surface of epitaxial film is specular surface.
As is clear from the table, with smaller ratio between the peak areas of the C 1*s* electron and N 1*s* electron (C 1*s* electron peak area / N 1*s* electron peak area) along the surface of a GaN substrate, haze occurrences in the epitaxial films tended to lessen. In particular, in the situation in which the ratio was 3 or less, no haze occurred in the epitaxial films, and high-quality epitaxial films could be grown.

Furthermore, a GaN substrate in which the ratio between the peak areas of the C1*s* electron and N1*s* electron (C 1*s* electron peak area / N 1*s* electron peak area) along the GaN substrate surface was 3 or less was a substrate cleaned with hydrochloric acid whose concentration with respect to the cleaning solution as a whole had been brought to 0.5% by mass or more, and whose GaN substrate immersion time was 30 seconds or more.

It should be understood that although GaN substrates were employed in Experimental Example 2, the same results are believed to be obtained if other Ga*ₓ*In_{1-*x*}N substrates, apart from GaN substrates, are employed. Furthermore, GaN substrate thickness and plane orientation are not limited to above example, and even where the thickness and plane orientation are arbitrary, the same results as in Experimental Example 2 will be obtained.

The presently disclosed embodiments and implementation examples should in all respects be considered to be illustrative and not limiting. The scope of the present invention is set forth not by the foregoing description but by the scope of the patent claims, and is intended to include meanings equivalent to the scope of the patent claims and all modifications within the scope.

### Industrial Applicability

The present invention can be advantageously be exploited in the manufacture of semiconductor devices employing Ga*ₓ*In_{1-*x*}N substrates.

## Claims

1. A Ga*ₓ*In_{1-*x*}N (0 ≤ *x* ≤ 1) substrate **characterized in that** the number of particles of not less than 0.2 µm particle size present on the Ga*ₓ*In_{1-*x*}N (0 ≤ *x* ≤ 1) substrate surface is 20 or fewer, given that the Ga*ₓ*In_{1-*x*}N (0 ≤ *x* ≤ 1) substrate diameter is 2 inches.

2. A Ga*ₓ*In_{1-*x*}N (0 ≤ *x* ≤ 1) substrate cleaning method **characterized in** immersing a Ga*ₓ*In_{1-*x*}N (0 ≤ *x* ≤ 1) substrate in a cleaning solution being any one substance selected from the group consisting of aqueous ammonia, ammonium hydroxide-hydrogen peroxide-water mixture, and aqueous organic alkali solutions, while applying ultrasonic waves to the solution, to bring the number of particles of not less than 0.2 µm particle size present on the Ga*ₓ*In_{1-*x*}N substrate surface to 20 or fewer, given that the Ga*ₓ*In_{1-*x*}N substrate diameter is 2 inches.

3. The Ga*ₓ*In_{1-*x*}N (0 ≤ *x* ≤ 1) substrate cleaning method set forth in claim 2, **characterized in that** as the cleaning solution, any one of aqueous ammonia
in which the ammonia concentration is 0.5% by mass or more, ammonium hydroxide-hydrogen peroxide-water mixture in which the aqueous hydrogen peroxide concentration is 0.1% by mass or more, with the ammonia concentration being 0.1% by mass or more, and an aqueous organic alkali solution in which the organic alkali concentration is 0.5% by mass or more is utilized.

4. The Ga*ₓ*In_{1-*x*}N (0 ≤ *x* ≤ 1) substrate cleaning method set forth in claim 2 or claim 3, **characterized in that** the aqueous organic alkali solution is a solution in which an organic alkali being one of either tetramethylammonium hydroxide or trimethyl-2-hidroxyethyl ammonium hydroxide is dissolved in water.

5. The Ga*ₓ*In_{1-*x*}N (0 ≤ *x* ≤ 1) substrate cleaning method set forth in any of claims 2 through 4, **characterized in that** the Ga*ₓ*In_{1-*x*}N substrate immersion time is 30 seconds or more.

6. A Ga*ₓ*In_{1-*x*}N (0 ≤ *x* ≤ 1) substrate **characterized in that** in a photoelectron spectrum along the Ga*ₓ*In_{1-*x*}N substrate surface by X-ray photoelectron spectroscopy at take-off angle of 10°, the ratio between the peak areas of the C1*s* electron and N1*s* electron (C 1*s* electron peak area / N 1*s* electron peak area) is 3 or less.

7. A Ga*ₓ*In_{1-*x*}N (0 ≤ *x* ≤ 1) substrate cleaning method **characterized in** immersing a Ga*ₓ*In_{1-*x*}N substrate in an acid solution to bring the ratio between the peak areas of the C1*s* electron and N1*s* electron (C 1*s* electron peak area/N 1*s* electron peak area) to 3 or less in a photoelectron spectrum along the Ga*ₓ*In_{1-*x*}N substrate surface by X-ray photoelectron spectroscopy at a take-off angle of 10°.

8. The Ga*ₓ*In_{1-*x*}N (0 ≤ *x* ≤ 1) substrate cleaning method set forth in claim 7, **characterized in that** the acid solution is composed of either at least one substance selected from the group consisting of fluoric acid, hydrochloric acid, and sulfuric acid, or an admixed solution of aqueous hydrogen peroxide and at least one substance selected from the group consisting of fluoric acid, hydrochloric acid, and sulfuric acid.

9. The Ga*ₓ*In_{1-*x*}N (0 ≤ *x* ≤ 1) substrate cleaning method set forth in claim 8, **characterized in that** wherein the acid solution is composed of at least one substance selected from the group consisting of fluoric acid, hydrochloric acid, and sulfuric acid, the total concentration of fluoric acid, hydrochloric acid, and sulfuric acid in the acid solution is 0.5% by mass or more, and wherein the acid solution is composed of an admixed solution of aqueous hydrogen peroxide and at least one substance selected from the group consisting of fluoric acid, hydrochloric acid, and sulfuric acid, the total concentration of fluoric acid, hydrochloric acid, and sulfuric acid in the acid solution is 0.1% by mass or more, with aqueous hydrogen peroxide concentration being 0.1% by mass or more.

10. The Ga*ₓ*In_{1-*x*}N (0 ≤ *x* ≤ 1) substrate cleaning method set forth in any of claims 7 through 9, **characterized in that** the Ga*ₓ*In_{1-*x*}N substrate immersion time is 30 seconds or more.
